# EUROPÄISCHE PATENTSCHRIFT

(11) **EP 4 652 463 B1**
(45) Veröffentlichungstag und Bekanntmachung des Hinweises auf die Patenterteilung: **23.09.2026**
(21) Anmeldenummer: 24700975.6
(22) Anmeldetag: 16.01.2024
(51) Int. Cl.: G01R 15/18, G01R 11/24, G01R 22/06, F16B 21/04, F16B 2/10

(54) **SICHERUNGSMITTEL FÜR EINEN BAJONETTVERSCHLUSS**
SECURING MEANS FOR A BAYONET COUPLING
DISPOSITIF DE FIXATION POUR COUPLAGE À BAÏONNETTE

(30) Priorität: 16.01.2023 BE 202305020
(43) Veröffentlichungstag der Anmeldung: 26.11.2025
(73) Patentinhaber: PHOENIX CONTACT GmbH & Co. KG, 32825 Blomberg (DE)
(72) Erfinder: HOBEIN, Jürgen, 31789 Hameln (DE)
(74) Vertreter: LifeTech IP Spies & Behrndt Patentanwälte PartG mbB
(86) Internationale Anmeldenummer: PCT/EP2024/050887
(87) Internationale Veröffentlichungsnummer: WO 2024/153626

(56) Entgegenhaltungen:
- EP-A2- 1 013 981
- WO-A1-2007/025494
- CN-U- 217 360 035
- DE-A1- 102019 130 281
- DE-U1- 202009 016 444
- US-A- 4 609 217
- US-A1- 2016 186 792

## Beschreibung

Die Erfindung betrifft ein Sicherungsmittel für einen Bajonettverschluss, das ein Öffnen des Bajonettverschlusses im geschlossenen Zustand des Sicherungsmittels verhindert. Ohne darauf beschränkt zu sein, betrifft die Erfindung insbesondere eine Vorrichtung zur Sicherung eines verriegelten Bajonettverschlusses für eine betriebsbereite Konfiguration eines Messgerätes, wobei die angezeigten Messwerte auf der andauernden Betriebsbereitschaft des Messgerätes beruhen. Für Wechselströme kann das Messgerät als Rogowski-Spule zur Strom- oder Leistungsmessung ausgeführt sein. Diese hat den Vorteil einer einfachen nachträglichen Montage, da die zu messende Leitung lediglich umfasst werden muss ohne weiteren Eingriff in die Schaltung oder Leitung.

Zum Stand der Technik gehört das Dokument EP1013981A2, welches eine Anordnung zum Verbinden zweier rohrförmiger Elemente beschreibt, insbesondere von Enden zweier Rohre einer Klimaanlage, mit zwei ineinandergreifenden Verriegelungsteilen, die zum Erreichen einer Verriegelungsstellung gegeneinander verdrehbar und in axialer Richtung gegeneinander verschiebbar sind (Bajonettverschluss). Mit der Maßgabe, dass die Verriegelungsteile jeweils mindestens zwei Teilelemente umfassen, wobei die Teilelemente in radialer Richtung durch zwei ineinandergreifende Hülsen fixiert sind.

Ferner beschreibt das Dokument US 2016/0186 792 A1 eine Verbindungsanordnung mit Bajonettverriegelung der Verbindungselemente. Gemäß dieser Offenbarung ist ein Teil vorgesehen, das dazu bestimmt ist, das Verriegelungselement des Bajonettsystems in der Position der gegenseitigen Verriegelung gegen eine Translationsbewegung zu blockieren, wobei das blockierende Teil abnehmbar auf dem Körper angeordnet ist, der die Bajonettöse trägt.

Das deutsche Gebrauchsmuster DE 20 2009 016 444 U1 beschreibt eine Manschette für Kupplungen von Feuerwehrschläuchen, die aus zwei oder mehr Elementen besteht, in welche die zusammengekuppelte Kupplung hineingelegt und durch Zusammenklappen der Elemente umschlossen wird.

Das Dokument US 4 609 217 A beschreibt eine Abdeckung für eine Mutter, die ein Gasversorgungsrohr an einem Gaszähler befestigt, die Angaben über unbefugte Eingriffe enthält. Die Abdeckung umfasst ein Paar "C"-förmiger, zusammenpassender Hohlraumabschnitte aus Kunststoff, die so geformt und bemessen sind, dass sie um die Oberseite, die Seiten und die Unterseite der Mutter passen, sowie einen Metallscharnierclip, der dazu ausgebildet ist, dauerhaft in das untere Ende jedes Hohlraumabschnitts eingerastet zu werden. Das obere Ende eines Hohlraumabschnitts wird am oberen Ende des anderen Hohlraumabschnitts entweder durch einen Metallclip befestigt, der dazu ausgebildet ist, in jedes Ende eingerastet zu werden, wenn eine dauerhafte Verbindung gewünscht wird, oder durch eine Drahtdichtung, die durch eine an jedem Ende ausgebildete Öffnung eingeführt wird, wenn eine nicht dauerhafte Verbindung gewünscht wird.

Die Internationale Patentanmeldung WO 2007/025494 A1 beschreibt wie bei einer hydraulischen Kupplung umfassend einen Stecker sowie einer Steckbuchse eine hohe axiale Andruckkraft zwischen Stecker und Steckbuchse ermöglicht wird, indem die Kupplung einen Bajonettverschluss umfasst, der vermittels eines mit der Kupplung verbindbaren Mittels zur Verdrehsicherung gegen Verdrehung gesichert ist.

Das Dokument DE 10 2019 130 281 A1 betrifft eine Anordnung mit einer Steckbuchse und mit einem Stecker zur Bildung eines Adapters zum Anschluss einer Hydraulikleitung der Anordnung an einen Gegenadapter eines Fahrzeugs. Die Steckbuchse und der Stecker zu dem Adapter sind mittels einer Formschlussverbindung verbindbar, wobei die Steckbuchse eine Formschlussschnittstelle aufweist und wobei der Stecker eine Formschlussgegenschnittstelle zur Bildung der Formschlussverbindung aufweist. Die Formschlussschnittstelle ist eine Öffnung, die in einer Draufsicht auf eine axiale Längserstreckung der Steckbuchse L-förmig mit einem ersten Schenkel und mit einem zweiten Schenkel ausgebildet ist.

Das Gebrauchsmuster CN 217 360 035 U bezieht sich auf eine Rogowski-Spulenanordnung und einen Rogowski-Spulenstromsensor. Eine Drahtwickelvorrichtung umfasst einen inneren Kern, einen auf den inneren Kern gewickelten Spiraldraht und einen Aufwickeldraht, der entlang der Längenausdehnungsrichtung des inneren Kerns verläuft, wobei eine Abschirmhülse außerhalb des Spiraldrahts gewickelt ist. Eine Abschirmhülse ist um den Spiraldraht gewickelt. Ein erster Anschluss ist an einem Ende der Spiralleitung installiert, ein zweiter Anschluss ist am anderen Ende der Spiralleitung installiert, ein dritter Anschluss ist an einem Ende der Aufwickelleitung installiert und ein vierter Anschluss ist am anderen Ende der Aufwickelleitung installiert.

Strom- oder Leistungsmessung können typischerweise zur Abrechnung der entsprechenden Verbräuche herangezogen werden. Dabei ist es zweckmäßig, die elektrische Schaltung und den Verbrauchsmesser, zum Beispiel die Rogowski-Spule, getrennt herzustellen und erst bei der Installation zusammenzuführen. Dabei ist es vorteilhaft, wenn die elektrische Schaltung nicht mehr verändert werden muss, zum Beispiel durch Einschleifung eines Messgerätes, da hierdurch in der Praxis Fehler auftreten können. Entsprechend kann für die Strom- oder Leistungsmessung die Rogowski-Spule zum Einsatz kommen, da diese in einem geöffneten Zustand um einen Leiter angeordnet werden kann, was lediglich entsprechend freien Bauraum um den Leiter herum voraussetzt. Sie liefert im geschlossenen Zustand die Verbrauchswerte.

Allerdings ist zur Vermeidung von Missbrauch der dauerhaft geschlossene Zustand der Messeinrichtung sicherzustellen, wobei der geschlossene Zustand häufig mit einem verriegelten Bajonettverschluss hergestellt wird.

Die Aufgabe wird mit den Merkmalen jedes der unabhängigen Ansprüche gelöst. Zweckmäßige Ausgestaltungen und vorteilhafte Weiterbildungen der Erfindung sind in den abhängigen Ansprüchen angegeben.

Die Überwachung des dauerhaft geschlossenen Zustands der Messeinrichtung kann mit einer zusätzlichen Vorrichtung geschehen, die eine Entriegelung des Bajonettverschlusses verhindert oder zumindest die Entriegelung des Bajonettverschlusses anzeigt.

Ausführungsbeispiele der Erfindung, die wahlweise miteinander kombinierbar sind, sind im Folgenden unter teilweiser Bezugnahme auf die Figuren offenbart.

Ein erster Aspekt betrifft eine Vorrichtung zur Sicherung eines verriegelten Bajonettverschlusses. Die Vorrichtung umfasst ein erstes Verriegelungssicherungselement, das ausgebildet ist, um den Bajonettverschluss in einem ersten Bereich zu umfassen. Weiter umfasst die Vorrichtung ein zweites Verriegelungssicherungselement, das ausgebildet ist, um den Bajonettverschluss in einem zweiten Bereich zu umfassen. Das erste und das zweite Verriegelungssicherungselement weist jeweils einen Sicherungsstift auf, wobei der jeweilige Sicherungsstift ausgebildet ist, um jeweils in einen Freiraum des Bajonettverschlusses einzugreifen, der zu einer Entriegelung von jeweils einem Bolzen des Bajonettverschlusses durchlaufen wird. Die Entriegelung des Bajonettverschlusses ist blockiert, wenn das erste und das zweite Verriegelungssicherungselement um den Bajonettverschluss angeordnet sind.

Vorteilhaft können so eine Mehrzahl von Sicherungsstiften passgerecht in dem Bajonettverschluss auf einfache Weise angeordnet werden.

Dabei können das erste und das zweite Verriegelungssicherungselement als Kunststoffteil ausgeführt sein, zum Beispiel als gespritztes Kunststoffteil. Es kann aber auch in Metall ausgeführt sein. Die Vorrichtung wird dabei am verriegelten Bajonettverschluss angeordnet. Die Verriegelungssicherungselemente können konstruktiv so ausgebildet sein, dass im geschlossenen Zustand der Vorrichtung diese formschlüssig mit dem Bajonettverschluss verbunden ist. Dazu können Laschen, Stege und dergleichen in entsprechende Aussparungen oder Formen des Bajonettverschluss fassen. Die beiden Verriegelungssicherungselemente können den Bajonettverschluss vollständig umfassen. Sie können den Bajonettverschluss alternativ auch nur teilweise umfassen, solange die formschlüssige Anordnung von Vorrichtung und Bajonettverschluss sichergestellt ist. Die Verriegelungssicherungselemente können spiegelbildlich zueinander ausgeführt sein, insbesondere bei einem symmetrisch aufgebauten Bajonettverschluss. Die Sicherungsstifte verhindern zuverlässig die vollständige Entriegelungsbewegung der Bolzen durch mechanische Verriegelung der Laufbahn, die sie zumindest in Teilen vollständig ausfüllen können. Die Anordnung der Vorrichtung erfolgt im Anschluss an die Verriegelung des Bajonettverschlusses.

In Ausführungsbeispielen können bei der Vorrichtung zur Sicherung eines verriegelten Bajonettverschlusses das erste Verriegelungssicherungselement und das zweite Verriegelungssicherungselement durch ein Scharnier miteinander verbunden sein. Dabei kann die Vorrichtung einen offenen Zustand einnehmen zum Anordnen der Vorrichtung um den Bajonettverschluss und einen geschlossenen Zustand einnehmen zum Blockieren des Bajonettverschlusses.

Vorteilhaft ist so eine einfache Anordnung beziehungsweise ein einfaches Entfernen der Vorrichtung gegeben, da die Anordnung der Verriegelungssicherungselemente zueinander vorgegeben ist.

Das Scharnier kann aus Elementen der Verriegelungssicherungselemente bestehen. Die Scharnierelemente können dabei durch Verschnappen, durch Einrasten oder Verdrehen zum Scharnier zusammengefügt werden. Das Scharnier kann aber auch als separates Element ausgeführt sein, zum Beispiel aus einem anderen Material als die Verriegelungssicherungselemente, insbesondere aus einem widerstandsfähigeren Kunststoff oder aus Metall. Das Scharnier ist im geschlossenen Zustand der Vorrichtung ohne Gewalteinwirkung nicht entfernbar oder zerlegbar.

In weiteren Ausführungsbeispielen kann bei der Vorrichtung zur Sicherung eines verriegelten Bajonettverschlusses das erste Verriegelungssicherungselement und/oder das zweite Verriegelungssicherungselement jeweils eine Aussparung zur Umfassung zumindest eines Teils des Bajonettverschlusses aufweisen. Jede der Aussparungen kann einen Sicherungsstift aufweisen, der in den jeweiligen Freiraum des Bajonettverschlusses hineinkragt. Das Hineinkragen kann optional senkrecht oder radial erfolgen.

Vorteilhaft kann so eine Mehrzahl von Sicherungsstiften passgerecht in dem Bajonettverschluss auf einfache Weise angeordnet werden.

Die Aussparung zur Umfassung zumindest eines Teils des Bajonettverschlusses dient der formschlüssigen Verbindung der Vorrichtung mit dem Bajonettverschluss, indem sie den konstruktiven Gegebenheiten des Bajonettverschlusses durch entsprechende eigene Formgebung folgt. Diese eigene Formgebung kann als die genannte Auskragung oder Ausnehmungen ausgebildet sein. Weiter kann bei Anordnung des Sicherungsstiftes in der Aussparung eine Beschädigung bei Herstellung, Lagerung und Montage vermieden werden.

In anderen Ausführungsbeispielen kann bei der Vorrichtung zur Sicherung eines verriegelten Bajonettverschlusses das erste Verriegelungssicherungselement und das zweite Verriegelungssicherungselement jeweils eine Bohrung zur Aufnahme eines Plombierdrahtes aufweisen. Diese kann so angeordnet sein, dass ein Plombierdraht im geschlossenen Zustand der Vorrichtung durch die Bohrungen einziehbar ist.

Vorteilhaft kann so die dauerhafte Anordnung der geschlossenen Vorrichtung um den Bajonettverschluss angezeigt werden bei unbeschädigter Plombe. Alternativ kann die Öffnung der Vorrichtung angezeigt werden bei beschädigter Plombe.

Plombierdrähte sind bekannt. Sie werden in Bohrungen, Ösen oder dergleichen angeordnet und mit einer Plombe verplombt, sodass eine Öffnung der Vorrichtung nur bei Zerstörung von Plombierdraht und/oder Plombe möglich ist. Eine Wiederherstellung nach der Zerstörung ist dabei nicht möglich oder sofort augenfällig. Darüber hinaus kann die Plombe beim Verplombungsvorgang mit einem Prägezeichen versehen werden, sodass die Augenfälligkeit einer möglichen Zerstörung noch offensichtlicher wird.

In Ausführungsbeispielen kann bei der Vorrichtung zur Sicherung eines verriegelten Bajonettverschlusses die Bohrung an einem dem Scharnier gegenüberliegenden Ende der Verriegelungssicherungselemente angeordnet sein. Weiter kann eine Länge und/oder Form des in der Bohrung aufgenommenen Plombierdrahtes den geschlossenen Zustand der Vorrichtung voraussetzten.

Vorteilhaft kann so eine vereinfachte Plombierung an nur einer Seite der Vorrichtung diese zuverlässig sichern. Dies wird noch verstärkt durch den kurzen Plombierdraht, der auch ein teilweises Öffnen der Vorrichtung verhindert.

Die Verriegelungssicherungselemente können eine längliche Form haben, die spiegelbildlich für das erste und das zweite Verriegelungssicherungselement ausgeführt ist. Dabei können ein Anfangssteg und ein Endsteg der Verriegelungssicherungselemente parallel zueinander ausgeführt sein und am Endsteg mit dem Scharnier gekoppelt sein. Die Anfangsstege und Endstege können sich im geschlossenen Zustand der Vorrichtung zumindest teilweise berühren. Mittig kann bei den Verriegelungssicherungselementen eine zum Beispiel halbkreisförmige Ausbuchtung zur Umfassung eines Teils des Bajonettverschlusses angeordnet sein. Die Anfangsstege weisen fluchtende Bohrungen für den Plombierdraht auf.

In weiteren Ausführungsbeispielen kann bei der Vorrichtung zur Sicherung eines verriegelten Bajonettverschlusses das erste Verriegelungssicherungselement eine erste Komponente einer elektronischen Plombiereinrichtung aufweisen. Weiter kann das zweite Verriegelungssicherungselement eine zweite Komponente der elektronischen Plombiereinrichtung aufweisen.

Vorteilhaft wird die elektronische Plombiereinrichtung nicht zerstört beim Öffnen der Plombierung. Intern kann die elektronische Plombiereinrichtung auch einen Zeitpunkt der Öffnung vermerken, zum Beispiel in einem Speicher, der von außen abfragbar ist. Dies kann auch eine Fernabfrage umfassen.

Die elektronische Plombiereinrichtung kann einen aktiven und einen passiven Teil umfassen, wobei der aktive Teil in dem ersten Verriegelungssicherungselement und der passive Teil in dem zweiten Verriegelungssicherungselement angeordnet sein können. Der passive Teil kann einen Magneten umfassen. Der aktive Teil der elektronischen Plombiereinrichtung wird mit elektrischer Energie für einen Näherungssensors des Magneten versorgt, zum Beispiel einer elektrischen Spule, einem Hallgeber oder dergleichen mehr. Die Stromversorgung kann kontinuierlich oder mit Unterbrechungen erfolgen zum Strom sparen.

In anderen Ausführungsbeispielen kann bei der Vorrichtung zur Sicherung eines verriegelten Bajonettverschlusses die elektronische Plombiereinrichtung ein Signal erzeugen oder verändern beim Öffnen der Vorrichtung. Weiter kann die elektronische Plombiereinrichtung einen Reed-Kontakt umfassen, der im geschlossenen Zustand der Vorrichtung geschlossen ist und im geöffneten Zustand der Vorrichtung geöffnet ist.

Vorteilhaft lässt sich durch ein einfaches elektronisches Bauteil, dem Reed-Kontakt, die Öffnung der Vorrichtung erfassen. Das erlaubt eine platz- und kostengünstige Lösung. Es kann zum Zeitpunkt der Verletzung der Plombierung ein Signal erzeugt beziehungsweise verändert werden. Das Signal (Plombierungssignal) kann eine externe Signalisierung bewirken, zum Beispiel in Form eines Alarms, der auch an eine Zentrale weitergeleitet werden kann. Entsprechend ermöglicht die elektronische Plombiereinrichtung eine sofortige Reaktion zum Zeitpunkt der Verletzung der Plombierung.

Das Signal kann zur Kombination mit Messsignalen geeignet sein, die zum Beispiel von einer Rogowski-Spule stammen. So kann das Signal einen Gleichstromanteil erzeugen, zum Beispiel ein 24 Volt Gleichstromsignal, während das Messsignal als Wechselstromsignal ausgebildet ist. Alternativ können Signal (Plombierungssignal) und Messsignal auf verschiedenen Trägern moduliert sein oder mit verschiedener Frequenz getaktet sein. Der Reed-Kontakt ist ausgebildet, bereits kleine Öffnungen der Vorrichtung zu erfassen. Die Weiterleitung des Alarms kann alternativ auch über einen digitalen Eingang eines benachbarten Gerätes geschehen, das seinerseits Kontakt zu der oben genannten Zentrale hat. Es können auch weitere Sensoren von der elektronischen Plombiereinrichtung umfasst sein, die wesentliche Eigenschaften der Messeinrichtung und/oder der Vorrichtung erfassen. Diese können Sensoren zur Kontakt-, Temperatur-, Erschütterungs-, Beschleunigungsüberwachung sein.

In Ausführungsbeispielen kann bei der Vorrichtung zur Sicherung eines verriegelten Bajonettverschlusses das erste und das zweite Verriegelungssicherungselement jeweils ein Arretierelement aufweisen. Das jeweilige Arretierelement kann dazu ausgebildet sein, die Vorrichtung im geschlossenen Zustand an einer axialen Bewegung bezogen auf den Bajonettverschluss zu hindern.

Vorteilhaft kann so ein Entfernen der Vorrichtung des Bajonettverschlusses ohne Öffnen der Plombierung verhindert werden. Weiter vorteilhaft kann die Platzierung der Sicherungsstifte ohne Rücksicht auf eine gegebene Abziehbarkeit der Vorrichtung von dem Bajonettverschluss erfolgen.

Hierbei kann sich axial auf eine Dreh- und/oder Steckachse des Bajonettverschlusses bezogen werden. Die axiale Bewegung kann vom jeweiligen Arretierelement im geschlossenen Zustand der Vorrichtung durch eine formschlüssige Verbindung mit dem verriegelten Bajonettverschlusses verhindert werden. Das Arretierelement kann an von den Sicherungsstiften abweichenden Stellen des Bajonettverschlusses eingreifen. Weiter können die Arretierelemente eine von den Sicherungsstiften abweichende mechanische Stabilität aufweisen. Sie können eine von den Sicherungsstiften abweichende Form und Dimension aufweisen. Sie können zum Beispiel stabiler ausgeführt sein, um die Abziehbarkeit der Vorrichtung vom Bajonettverschluss zu erschweren. Die Sicherungsstifte können am längs geschlitzten Ausgang des Bajonettverschlusses (dem Freiraum), das heißt dem axial ausgeformten Teil des Ausgangs des Bajonettverschlusses angeordnet sein zur Aufnahme des Bolzens des Bajonettverschlusses.

In weiteren Ausführungsbeispielen kann bei der Vorrichtung zur Sicherung eines verriegelten Bajonettverschlusses das jeweilige Arretierelement dazu ausgebildet sein, im geschlossenen Zustand in jeweils einen weiteren Freiraum des Bajonettverschlusses einzugreifen oder hinter einen Steg des Bajonettverschlusses zu greifen.

Vorteilhaft kann so eine Anpassung des Bajonettverschlusses an die Vorrichtung unterbleiben. Stattdessen werden die konstruktiven Gegebenheiten des vorhandenen Bajonettverschlusses ausgenutzt zur Erzielung der Haltefunktion.

Die Arretierelemente können in Aufnahmen des Bajonettverschlusses eingreifen, die bereits für andere Funktionen angelegt sind. Zum Beispiel können die Aufnahmen für Rastzungen des Bajonettverschlusses angelegt sein, die den Bajonettverschluss an einer Rotationsbewegung gegenüber einem angrenzenden Flansch hindern. Die Arretierelemente können dabei konstruktiv so ausgeführt sein, dass die Rastzungen ihre Funktion ungestört ausüben können. Die Arretierelemente können auch hinter Stege oder Auskragungen des Bajonettverschlusses greifen. Die Arretierelemente sind in ihrer konstruktiven Ausprägung und Anordnung durch vorhandene Befestigungspunkte des Bajonettverschlusses beeinflusst.

In anderen Ausführungsbeispielen kann ein Bajonettverschluss mit einer Vorrichtung zur Sicherung ausgebildet sein, wobei die Bolzen des Bajonettverschlusses und die weiteren Freiräume oder der Steg des Bajonettverschlusses axial in abweichenden Positionen voneinander angeordnet sein können.

Vorteilhaft kann so die gesamte axiale Länge des Bajonettverschlusses zur Anordnung von Sicherungsstiften und Arretierelementen der Vorrichtung genutzt werden.

Der Bajonettverschluss kann entlang seiner axialen Länge Zonen verschiedener Stabilität aufweisen. So können die verschiedenen Zonen verschiedene axiale Längen und/oder verschiedene Durchmesser aufweisen, die mit zusätzlichem Material hergestellt sind. Entsprechend kann durch die Anordnung der Arretierelemente mit zusätzlichem Material die Stabilität der Arretierung verbessert werden. Weiter können so alle vorhandenen Aufnahmen, Freiräume, Stege oder andere konstruktiven Merkmale des Bajonettverschlusses für die Arretierelemente genutzt werden, ohne auf die axiale Position der Bolzen des Bajonettverschlusses beschränkt zu sein.

In Ausführungsbeispielen kann eine Rogowski-Spule mit einem Bajonettverschluss mit einer Vorrichtung zur Sicherung des Bajonettverschlusses im geöffneten Zustand des Bajonettverschlusses eine Montage der Rogowski-Spule um einen elektrischen Leiter erlauben. Der Bajonettverschluss kann im geschlossenen Zustand eine Messanordnung der Rogowski-Spule herstellen.

Vorteilhaft kann so ein Anordnen oder ein Entfernen der Rogowski-Spule auf einfache Weise erreicht werden.

Die Rogowski-Spule besteht aus einem im Wesentlichen ringförmigen Leiter, der eine geöffnete Stellung, die Montagestellung, und eine geschlossene Stellung, die Messstellung, umfasst. Durch die Nutzung des Bajonettverschlusses zur Herstellung beider Zustände kann die Montagestellung beziehungsweise die Messstellung durch eine simple Handhabung erreicht werden. Im geöffneten Zustand des Bajonettverschlusses kann eine Montage der Rogowski-Spule um einen zu messenden Leiter erfolgen. Im geschlossenen Zustand des Bajonettverschlusses kann ein vordefinierter Abstand der beiden Enden der Rogowski-Spule zueinander eingestellt werden. Beide Enden der Rogowski-Spule führen in einem Messkopf. Die Rogowski-Spule ist an einem ersten Ende mit ihrem Messkopf fest verbunden und an einem zweiten Ende (das am Messkopf dem ersten Ende gegenüberliegt) mittels des Bajonettverschlusses lösbar verbunden oder verbindbar.

In weiteren Ausführungsbeispielen kann bei der Rogowski-Spule mit einem Bajonettverschluss mit einer Vorrichtung ein Gesamtsignal einen Messwert der Rogowski-Spule und das Signal der elektronischen Plombiereinrichtung umfassen.

Vorteilhaft kann so der Bedarf an Übertragungskanälen minimiert werden.

Der Übertragungskanal kann als Kabel ausgeführt sein, zum Beispiel als geschirmtes Kabel, um die niedrigen Spannungspegel des Messsignals (<=3mV) vor Verfälschung zu schützen. Es kann aber auch als Funkstrecke ausgebildet sein, zum Beispiel nach einem gängigen Funkstandard. Dabei kann der Funkstandard Kurzstrecken-Funkstandards mit räumlich naher Gegenstelle, zum Beispiel als Bluetooth oder NFC (Nahfeldkommunikation, fachsprachlich "Near Field Communication"), ausgeführt sein. Es kann aber auch ein Standard des zellularen Mobilfunks zur Anwendung kommen.

In anderen Ausführungsbeispielen kann bei einer Rogowski-Spule mit einem Bajonettverschluss mit einer Vorrichtung der Messwert der Rogowski-Spule als Wechselstrom mit einer ersten Frequenz ausgebildet sein, insbesondere der Netzfrequenz des gemessenen Stroms. Das Signal der elektronischen Plombiereinrichtung kann als Gleichstromsignal ausgebildet sein, oder als Wechselstrom mit einer von der ersten Frequenz abweichenden zweiten Frequenz.

Vorteilhaft kann so eine einfache Trennbarkeit vom Messsignal der Rogowski-Spule und dem Signal (Plombierungssignal) erreicht werden.

Die elektronische Plombierung der Vorrichtung, die zum Beispiel als Reed-Kontakt ausgeführt sein kann, kann bei Öffnung der Plombierung die Messung der Rogowski-Spule unterbrechen. Entsprechend entfällt dann auch die Übertragung des Messsignals. Alternativ kann auch lediglich das Plombierungssignal entfallen, während das gegebenenfalls verfälschte Messsignal weiter übertragen wird. Das Messsignal kann eine Spannung von bis zu 3mV aufweisen. Es basiert auf der Induktionsspannung des gemessenen Wechselstroms bei 50Hz oder der vorliegenden Netzfrequenz. Das Plombierungssignal wird mit einer anderen Frequenz oder als Gleichstromanteil des Gesamtsignals übertragen. Bei Übertragung nach einem Funkstandard können Messsignal und Plombierungssignal auch kodiert übertragen werden, zum Beispiel in Datenfeldern.

In Ausführungsbeispielen kann bei der Rogowski-Spule mit einem Bajonettverschluss mit einer Vorrichtung zur Sicherung die Vorrichtung nicht verlierbar an der zirkularen Leitung der Rogowski-Spule angeordnet sein.

Vorteilhaft kann so die Handhabung der Rogowski-Spule mit Bajonettverschluss und Vorrichtung weiter vereinfacht werden. Handhabung, Logistik und Montage sind weniger aufwändig oder fehleranfällig durch die gesicherte Präsenz der Vorrichtung zur Sicherung.

Bei der Anordnung der Vorrichtung an der zirkularen Leitung der Rogowski-Spule kann die Vorrichtung als separates Element auf der Spule angeordnet sein. Sie kann alternativ auch mit einem der Verriegelungssicherungselemente verbunden sein.

In weiteren Ausführungsbeispielen kann bei der Rogowski-Spule mit einem Bajonettverschluss mit einer Vorrichtung zur Sicherung die Vorrichtung einen Ring oder ein Oval umfassen, der oder das um die zirkulare Leitung der Rogowski-Spule angeordnet ist. Der Ring oder das Oval kann an das erste oder das zweite Verriegelungssicherungselement oder das Scharnier gekoppelt sein.

Vorteilhaft kann so die Handhabung der Rogowski-Spule mit Bajonettverschluss und Vorrichtung weiter vereinfacht werden.

Der Ring oder das Oval hat eine Größe (einen inneren Freiraum), die die ordnungsgemäße Anordnung der Vorrichtung erlaubt. Die Größe kann den 4- bis 10-fachen Durchmesser der Rogowski-Spule einnehmen. Der Ring oder das Oval kann auch als Klipp ausgeführt sein, der auf die Rogowski-Spule aufgeschnappt ist. Zur Anordnung der Vorrichtung um den Bajonettverschluss wird die Vorrichtung von der Spule gelöst. In diesem Fall kann die als runder oder ovaler Klipp ausgeführte Vorrichtung einer vereinfachten Handhabung dienen.

Nachfolgend wird die Erfindung unter Bezugnahme auf die anliegenden Zeichnungen anhand bevorzugter Ausführungsformen, die wahlweise miteinander kombinierbar sind, näher erläutert.

Es zeigen:
- Fig. 1: eine schematische Blockdarstellung einer Vorrichtung zur Sicherung eines verriegelten Bajonettverschlusses in einer ersten Ausführungsform in einem ersten Zustand,
- Fig. 2: eine schematische Blockdarstellung einer Vorrichtung zur Sicherung eines verriegelten Bajonettverschlusses in einer ersten Ausführungsform in einem zweiten Zustand,
- Fig. 3: eine schematische Blockdarstellung einer Vorrichtung zur Sicherung eines verriegelten Bajonettverschlusses in einer zweiten Ausführungsform,
- Fig. 4: eine schematische Blockdarstellung einer Vorrichtung zur Sicherung eines verriegelten Bajonettverschlusses in einer dritten Ausführungsform,
- Fig. 5: eine schematische Blockdarstellung einer Vorrichtung zur Sicherung eines verriegelten Bajonettverschlusses in einer vierten Ausführungsform in einem ersten Zustand,
- Fig. 6: eine schematische Blockdarstellung einer Vorrichtung zur Sicherung eines verriegelten Bajonettverschlusses in einer vierten Ausführungsform in einem zweiten Zustand,
- Fig. 7: eine schematische Blockdarstellung einer Vorrichtung zur Sicherung eines verriegelten Bajonettverschlusses in einer fünften Ausführungsform,
- Fig. 8: eine schematische Blockdarstellung eines Bajonettverschlusses,
- Fig. 9: eine schematische Blockdarstellung einer Rogowski-Spule in einer ersten Ausführungsform, und
- Fig. 10: eine schematische Blockdarstellung einer Rogowski-Spule in einer zweiten Ausführungsform.

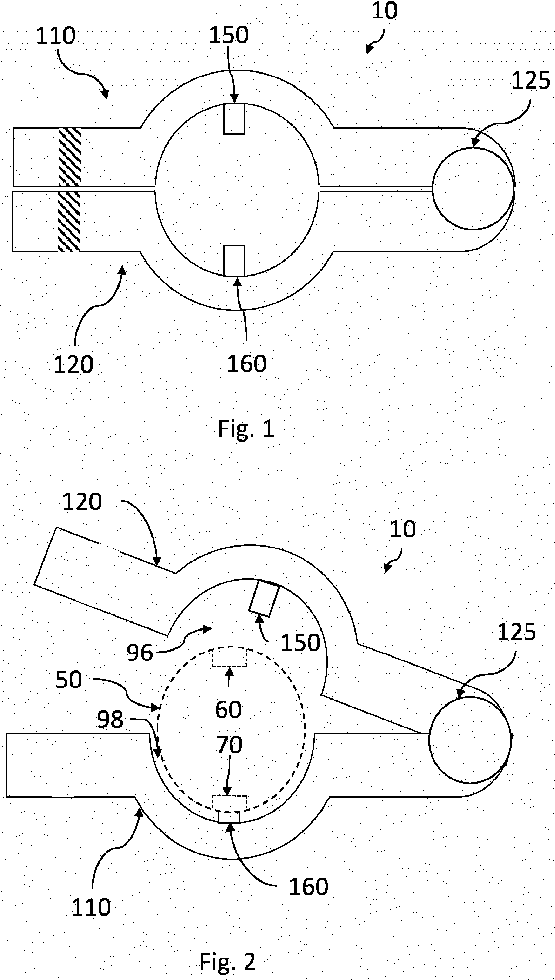

Fig. 1 zeigt eine schematische Blockdarstellung einer Vorrichtung zur Sicherung eines verriegelten Bajonettverschlusses in einer ersten Ausführungsform in einem ersten Zustand. Die Vorrichtung 10 zur Sicherung eines verriegelten Bajonettverschlusses 50 (siehe Fig. 2) umfasst ein erstes Verriegelungssicherungselement 110, das ausgebildet ist, um den Bajonettverschluss 50 in einem ersten Bereich zu umfassen. Weiter umfasst die Vorrichtung ein zweites Verriegelungssicherungselement 120, das ausgebildet ist, um den Bajonettverschluss 50 in einem zweiten Bereich zu umfassen. Das erste und das zweite Verriegelungssicherungselement 110, 120 weist jeweils einen Sicherungsstift 150, 160 auf, wobei der jeweilige Sicherungsstift 150, 160 ausgebildet ist jeweils in einen Freiraum 60, 70 des Bajonettverschlusses 50 einzugreifen, der zu einer Entriegelung von jeweils einem Bolzen 80, 90 des Bajonettverschlusses 50 durchlaufen wird. Die Entriegelung des Bajonettverschlusses 50 ist blockiert, wenn das erste und das zweite Verriegelungssicherungselement 110, 120 um den Bajonettverschluss 50 angeordnet ist.

Fig. 2 zeigt eine schematische Blockdarstellung einer Vorrichtung zur Sicherung eines verriegelten Bajonettverschlusses in einer ersten Ausführungsform in einem zweiten Zustand. Die Vorrichtung 10 zur Sicherung eines verriegelten Bajonettverschlusses 50 zeigt, dass das erste Verriegelungssicherungselement 110 und das zweite Verriegelungssicherungselement 120 durch ein Scharnier 125 miteinander verbunden sind. Die Vorrichtung 10 kann einen offenen Zustand einnehmen zum Anordnen der Vorrichtung um den Bajonettverschluss 50 und einen geschlossenen Zustand einnehmen (siehe Fig. 1) zum Blockieren des Bajonettverschlusses 50.

Weiter weist bei der Vorrichtung 10 zur Sicherung eines verriegelten Bajonettverschlusses das erste Verriegelungssicherungselement 110 und/oder das zweite Verriegelungssicherungselement 120 jeweils eine Aussparung 96, 98 zur Umfassung zumindest eines Teils des Bajonettverschlusses 50 auf. Jede der Aussparungen 96, 98 weist einen der Sicherungsstifte 150, 160 auf, der in den jeweiligen Freiraum 60, 70 des Bajonettverschlusses 50 hineinkragt oder hineinkragen kann. Das Hineinkragen kann optional senkrecht (nicht gezeigt) oder radial erfolgen.

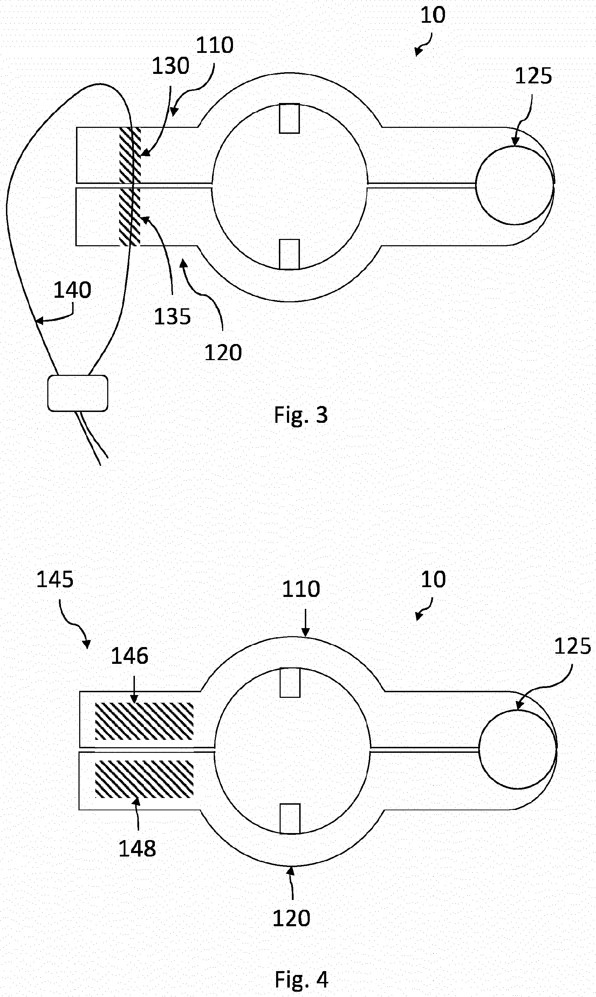

Fig. 3 zeigt eine schematische Blockdarstellung einer Vorrichtung zur Sicherung eines verriegelten Bajonettverschlusses in einer zweiten Ausführungsform. Bei der Vorrichtung 10 zur Sicherung eines verriegelten Bajonettverschlusses 50 weist das erste Verriegelungssicherungselement 110 und das zweite Verriegelungssicherungselement 120 jeweils eine Bohrung 130, 135 zur Aufnahme eines Plombierdrahtes 140 auf, die so angeordnet ist, dass ein Plombierdraht 140 im geschlossenen Zustand der Vorrichtung 10 durch die Bohrungen 130, 135 einziehbar ist.

Dabei sind in der Vorrichtung 10 zur Sicherung eines verriegelten Bajonettverschlusses 50 die Bohrung 130, 135 an einem dem Scharnier 125 gegenüberliegenden Ende der Verriegelungssicherungselemente 110, 120 angeordnet. Eine Länge und/oder Form des in den Bohrungen 130, 135 aufgenommenen oder aufzunehmenden Plombierdrahtes 140 setzt den geschlossenen Zustand der Vorrichtung (10) voraus.

Fig. 4 zeigt eine schematische Blockdarstellung einer Vorrichtung zur Sicherung eines verriegelten Bajonettverschlusses in einer dritten Ausführungsform. In der Vorrichtung 10 zur Sicherung eines verriegelten Bajonettverschlusses 50 weist das erste Verriegelungssicherungselement 110 eine erste Komponente 146 einer elektronischen Plombiereinrichtung 145 auf. Das zweite Verriegelungssicherungselement 120 weist eine zweite Komponente 148 der elektronischen Plombiereinrichtung 145 auf. Die erste Komponente 146 und die zweite Komponente 148 der elektronische Plombiereinrichtung 145 sind im geschlossenen Zustand der Vorrichtung 10 einander gegenüberliegend angeordnet auf der dem Scharnier 125 gegenüberliegenden Seite der Verriegelungssicherungselemente 110, 120. Die erste Komponente 146 und die zweite Komponente 148 der elektronische Plombiereinrichtung 145 können in einem alternativen Ausführungsbeispiel auch angrenzend an das Scharnier 125 in den Verriegelungssicherungselemente 110, 120 angeordnet sein (nicht gezeigt). Bei der Vorrichtung 10 zur Sicherung eines verriegelten Bajonettverschlusses 50 erzeugt oder verändert die elektronische Plombiereinrichtung 145 ein Signal beim Öffnen der Vorrichtung 10. Die elektronische Plombiereinrichtung 145 umfasst einen Reed-Kontakt (nicht gezeigt), der im geschlossenen Zustand der Vorrichtung 10 geschlossen ist und im geöffneten Zustand der Vorrichtung 10 geöffnet ist.

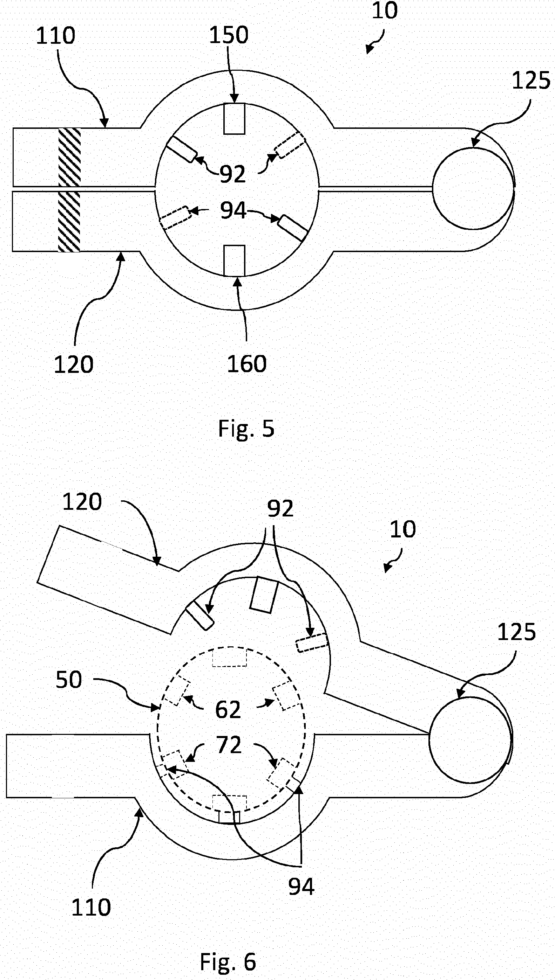

Fig. 5 zeigt eine schematische Blockdarstellung einer Vorrichtung zur Sicherung eines verriegelten Bajonettverschlusses in einer vierten Ausführungsform in einem ersten Zustand. Bei der Vorrichtung 10 zur Sicherung eines verriegelten Bajonettverschlusses 50 weist das erste und das zweite Verriegelungssicherungselement 110, 120 jeweils ein Arretierelement 92, 94 auf. Ein jeweils zweites Arretierelement 92, 94 kann optional angeordnet sein und ist gestrichelt dargestellt. Das jeweilige Arretierelement 92, 94 ist dazu ausgebildet, die Vorrichtung 10 im geschlossenen Zustand an einer axialen Bewegung bezogen auf den Bajonettverschluss 50 zu hindern.

Fig. 6 zeigt eine schematische Blockdarstellung einer Vorrichtung zur Sicherung eines verriegelten Bajonettverschlusses in einer vierten Ausführungsform in einem zweiten Zustand. In der Vorrichtung 10 zur Sicherung eines verriegelten Bajonettverschlusses 50 ist das jeweilige Arretierelement 92, 94 dazu ausgebildet, im geschlossenen Zustand in jeweils einen weiteren Freiraum 62, 72 des Bajonettverschlusses 50 einzugreifen oder hinter einen Steg (nicht gezeigt) des Bajonettverschlusses 50 zu greifen.

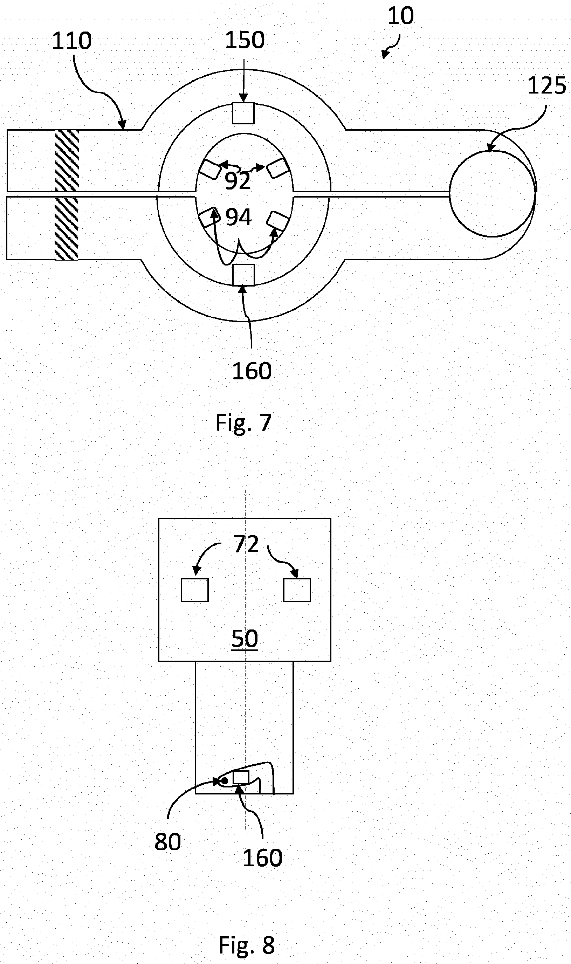

Fig. 7 zeigt eine schematische Blockdarstellung einer Vorrichtung zur Sicherung eines verriegelten Bajonettverschlusses in einer fünften Ausführungsform. Die Vorrichtung 10 ist für einen Bajonettverschluss 50 mit axial voneinander abweichenden Positionen ausgebildet. Hierbei sind die Sicherungsstifte 150, 160 der Vorrichtung in einem Bereich mit größeren Durchmesser des Bajonettverschlusses 50 angeordnet in einer ersten axialen Position. Die Arretierelemente 92, 94 der Vorrichtung sind in einem Bereich mit kleinerem Durchmesser des Bajonettverschlusses 50 angeordnet in einer zweiten axialen Position. Hierbei kann sich axial auf eine Dreh- und/oder Steckachse des Bajonettverschlusses bezogen werden. Die axiale Bewegung kann vom jeweiligen Arretierelement 92, 94 im geschlossenen Zustand durch eine formschlüssige Verbindung mit dem verriegelten Bajonettverschlusses 50 verhindert werden.

Fig. 8 zeigt eine schematische Blockdarstellung eines Bajonettverschlusses. Bei dem Bajonettverschluss 50 mit einer Vorrichtung 10 (nicht gezeigt) sind die Bolzen 80, 90 des Bajonettverschlusses 50 und die weiteren Freiräume 62, 72 oder der Steg (nicht gezeigt) des Bajonettverschlusses 50 axial in abweichenden Positionen voneinander angeordnet. Entsprechend Fig. 7 sind die weiteren Freiräume 62, 72 oder der Steg in einem Bereich mit größerem Durchmesser des Bajonettverschlusses angeordnet. Die Bolzen 80, 90 sind einem Bereich mit kleinerem Durchmesser angeordnet. Die Bolzen 80, 90 sind am lösbaren Teil (nicht gezeigt) des Bajonettverschlusses 50 befestigt.

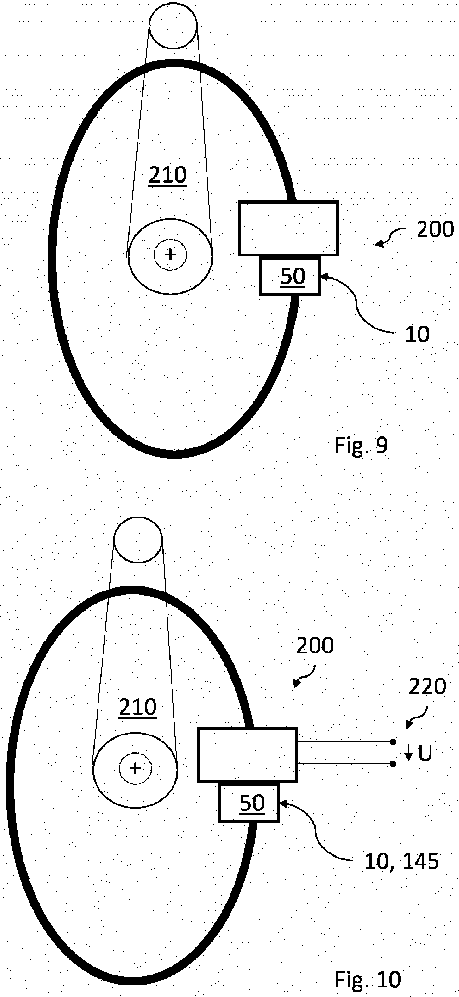

Fig. 9 zeigt eine schematische Blockdarstellung einer Rogowski-Spule in einer ersten Ausführungsform. Bei der Rogowski-Spule 200 mit einem Bajonettverschluss 50 mit einer Vorrichtung 10 erlaubt der Bajonettverschluss 50 im geöffneten Zustand (nicht gezeigt) eine Montage der Rogowski-Spule 200 um einen elektrischen Leiter 210. Der Bajonettverschluss 50 im geschlossenen Zustand stellt eine Messanordnung der Rogowski-Spule 200 her. Die Rogowski-Spule ist an einem ersten Ende mit dem Messkopf fest verbunden und an einem zweiten Ende (das am Messkopf dem ersten Ende gegenüberliegt) mittels des Bajonettverschlusses lösbar verbunden oder verbindbar. Im geschlossenen Zustand führt auch das zweite Ende in den Messkopf.

Fig. 10 zeigt eine schematische Blockdarstellung einer Rogowski-Spule in einer zweiten Ausführungsform. Bei der Rogowski-Spule 200 mit einem Bajonettverschluss 50 mit einer Vorrichtung 10 zur Sicherung umfasst ein Gesamtsignal U einen Messwert der Rogowski-Spule 200 und das Signal 220 der elektronischen Plombiereinrichtung 145.

Dabei kann der Messwert der Rogowski-Spule 200 als Wechselstrom mit einer ersten Frequenz ausgebildet sein, insbesondere der Netzfrequenz des gemessenen Stroms. Das Signal der elektronischen Plombiereinrichtung 145 kann als Gleichstromsignal ausgebildet sein oder als Wechselstrom mit einer von der ersten Frequenz abweichenden zweiten Frequenz.

Ergänzend kann bei der Rogowski-Spule 200 mit einem Bajonettverschluss 50 mit einer Vorrichtung 10 zur Sicherung die Vorrichtung 10 nicht verlierbar (nicht gezeigt) an der zirkularen Leitung der Rogowski-Spule 200 angeordnet sein.

Schließlich kann die Rogowski-Spule 200 mit einem Bajonettverschluss 50 mit einer Vorrichtung 10 zur Sicherung die Vorrichtung 10 einen Ring (nicht gezeigt) oder ein Oval (nicht gezeigt) umfassen, der oder das um die zirkulare Leitung der Rogowski-Spule 200 angeordnet ist. Der Ring oder das Oval kann mit dem ersten oder zweiten Verriegelungssicherungselement 110, 120 oder dem Scharnier 125 gekoppelt sein.

Mit anderen Worten kann die Erfindung wie folgt beschrieben werden. Grundsätzlich werden Rogowski-Spulen 200 zur Strommessung von Wechselströmen (AC) genutzt.

Der gravierende Vorteil von Rogowski-Spulen 200 ist die sogenannte Nachrüstbarkeit (fachsprachlich Retrofit) in bestehende elektrische Anlagen. Nachrüstbarkeit bedeutet, dass die Spule 200 bautechnisch geöffnet werden kann, also teilbar ist. Der erforderliche Aufwand, um einen aktiven Messpunkt im Feld zu erzeugen, ist sehr gering und innerhalb kurzer Zeit durchzuführen, zum Beispiel innerhalb einer Minute.

Bei der Installation der Rogowski-Spule 200 ist diese mit einem Handgriff entsperrbar. Dies wird erreicht, indem der Bajonettverschluss 50 um 90° gegen den Uhrzeigersinn gedreht wird. Danach kann die Spule 200 aus dem Bajonettverschluss herausgezogen werden, das heißt vom Gehäuse der Rogowski-Spule weggezogen werden. Anschließend wird die Rogowski-Spule 200 um den stromführenden Leiter herumgezogen und wieder in den Bajonettverschluss 50 eingeführt. Mit einer weiteren 90°-Drehung des Bajonettverschlusses (jetzt im Uhrzeigersinn) ist der Verschluss wieder verriegelt. Die Spule ist in der richtigen Position. Die Installation ist damit komplett.

Für die Strommessung ist es wichtig, dass die Rogowski-Spule 200 korrekt installiert ist. Das bedeutet in diesem Fall, dass sich das Ende der Rogowski-Spule 200 während der Strommessung im verriegelten Bajonettverschluss 50 befindet. Wäre dies nicht so, wäre der gemessene Strommesswert viel kleiner als der tatsächlich vorhandene Strompegel, sodass eine Differenz auftritt, die monetären Schaden verursachen kann.

Künftig ist davon auszugehen, dass auch Rogowski-Spuken für MID-Messungen (fachsprachlich: "Measuring Instruments Directive") eingesetzt werden können, beispielsweise gemäß der Richtlinie 2004/22/EG bzw. Richtlinie 2014/32/EU über Messgeräte, kurz Messgeräterichtlinie. Hierbei handelt es sich um Strom- bzw. Leistungsmessungen für monetäre Verrechnungszwecke an Dritte, zum Beispiel an Kunden. Wenn es um monetäre Verrechnungszwecke geht, muss gewährleistet sein, dass die komplette Messeinrichtung gegen mögliche Manipulationsversuche geschützt ist. Daher soll erfinderisch eine zusätzliche Vorrichtung die im Betrieb befindliche Strommessung vor illegalem Zugriff sichern.

Dazu muss der Bajonettverschluss 50 blockiert sein gegen seitliches Verdrehen, um das illegale Herausziehen aus der korrekten Messposition der Rogowski-Spule 200 zu verhindern. Dazu wird ein zusätzliches Kunststoffteil in Form der Vorrichtung 10 auf einer Ober- und Unterseite des Bajonettverschlusses 50 installiert. Im geöffneten Zustand der Vorrichtung 10 wird der Manipulationsschutz um den Bajonettverschluss 50 in Position gebracht und mittels des Scharniers geschlossen. Dabei greifen einige "Zähne" (Sicherungsstifte 150, 160 und Arretierelement 92, 94) der Vorrichtung 10 in die Aussparungen (Freiräume 60, 70 und weitere Freiräume 62, 72) des Bajonettverschlusses 50 und blockieren ihn auf diese Weise. Abschließend wird durch ein Langloch (Bohrung 130, 135) ein Plombierdraht 140 gezogen und verplombt. Dadurch ist der Schutz vor Manipulation gegeben.

Obwohl die Erfindung in Bezug auf exemplarische Ausführungsbeispiele beschrieben worden ist, ist für Fachkundige ersichtlich, dass verschiedene Änderungen vorgenommen werden können. Ferner können viele Modifikationen vorgenommen werden, um eine bestimmte Situation oder ein bestimmtes Material an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

### Bezugszeichen

- 10: Vorrichtung
- 50: Bajonettverschluss
- 60: Erster Freiraum des Bajonettverschlusses
- 62: Erster weiterer Freiraum des Bajonettverschlusses
- 70: Zweiter Freiraum des Bajonettverschlusses
- 72: Zweiter weiterer Freiraum des Bajonettverschlusses
- 80: Erster Bolzen des Bajonettverschlusses
- 90: Zweiter Bolzen des Bajonettverschlusses
- 92: Erstes Arretierelement der Vorrichtung
- 94: Zweites Arretierelement der Vorrichtung
- 96: Erste Aussparung der Vorrichtung
- 98: Zweite Aussparung der Vorrichtung
- 110: Erstes Verriegelungssicherungselement der Vorrichtung
- 120: Zweites Verriegelungssicherungselement der Vorrichtung
- 125: Scharnier der Vorrichtung
- 130: Bohrung im ersten Verriegelungssicherungselement
- 135: Bohrung im zweiten Verriegelungssicherungselement
- 140: Plombierdraht
- 145: Elektronische Plombiereinrichtung
- 146: Erste Komponente der elektronischen Plombiereinrichtung
- 148: Zweite Komponente der elektronischen Plombiereinrichtung
- 150: Erster Sicherungsstift der Vorrichtung
- 160: Zweiter Sicherungsstift der Vorrichtung
- 200: Rogowski-Spule
- 210: Zu messender elektrischer Leiter
- 220: Signal der Rogowski-Spule und/oder der Plombierung

## Patentansprüche

1. Vorrichtung (10) zur Sicherung eines verriegelten Bajonettverschlusses (50), umfassend:
ein erstes Verriegelungssicherungselement (110), das dazu ausgebildet ist, den Bajonettverschluss (50) in einem ersten Bereich zu umfassen,
ein zweites Verriegelungssicherungselement (120), das dazu ausgebildet ist, den Bajonettverschluss (50) in einem zweiten Bereich zu umfassen,
wobei das erste und das zweite Verriegelungssicherungselement (110, 120) jeweils einen Sicherungsstift (150, 160) aufweist, wobei der jeweilige Sicherungsstift (150, 160) dazu ausgebildet ist, jeweils in einen Freiraum (60, 70) des Bajonettverschlusses (50) einzugreifen, der zu einer Entriegelung von jeweils einem Bolzen (80, 90) des Bajonettverschlusses (50) durchlaufen wird, und
wobei die Entriegelung des Bajonettverschlusses (50) blockiert ist, wenn das erste und das zweite Verriegelungssicherungselement (110, 120) um den Bajonettverschluss (50) angeordnet ist.

2. Vorrichtung (10) zur Sicherung eines verriegelten Bajonettverschlusses (50) nach Anspruch 1, wobei das erste Verriegelungssicherungselement (110) und das zweite Verriegelungssicherungselement (120) durch ein Scharnier (125) miteinander verbunden oder verbindbar sind,
wobei die Vorrichtung (10) einen offenen Zustand zum Anordnen der Vorrichtung (10) um den Bajonettverschluss (50) und einen geschlossenen Zustand zum Blockieren des Bajonettverschlusses (50) einzunehmen vermag.

3. Vorrichtung (10) zur Sicherung eines verriegelten Bajonettverschlusses (50) nach Anspruch 1 oder 2,
wobei das erste Verriegelungssicherungselement (110) und/oder das zweite Verriegelungssicherungselement (120) jeweils eine Aussparung (96, 98) zur Umfassung zumindest eines Teils des Bajonettverschlusses (50) aufweist, und
wobei jede der Aussparung (96, 98) einen Sicherungsstift (150, 160) aufweist, der in den jeweiligen Freiraum (60, 70) des Bajonettverschlusses (50) hineinkragt, optional senkrecht oder radial.

4. Vorrichtung (10) zur Sicherung eines verriegelten Bajonettverschlusses (50) nach einem der Ansprüche 1 bis 3,
wobei das erste Verriegelungssicherungselement (110) und das zweite Verriegelungssicherungselement (120) jeweils eine Bohrung (130, 135) zur Aufnahme eines Plombierdrahtes (140) aufweist, die so angeordnet ist, dass ein Plombierdraht (140) im geschlossenen Zustand der Vorrichtung (10) durch die Bohrungen (130, 135) einziehbar ist.

5. Vorrichtung (10) zur Sicherung eines verriegelten Bajonettverschlusses (50) nach Anspruch 4,
wobei die Bohrung (130, 135) an einem dem Scharnier (125) gegenüberliegenden Ende der Verriegelungssicherungselemente (110, 120) angeordnet ist, und/oder
wobei eine Länge und/oder Form des in der Bohrung (130, 135) aufgenommenen Plombierdrahtes (140) den geschlossenen Zustand der Vorrichtung (10) voraussetzt.

6. Vorrichtung (10) zur Sicherung eines verriegelten Bajonettverschlusses (50) nach einem der Ansprüche 1 bis 5,
wobei das erste Verriegelungssicherungselement (110) eine erste Komponenten (146) einer elektronischen Plombiereinrichtung (145) aufweist, und/oder
wobei das zweite Verriegelungssicherungselement (120) eine zweite Komponenten (148) der elektronischen Plombiereinrichtung (145) aufweist.

7. Vorrichtung (10) zur Sicherung eines verriegelten Bajonettverschlusses (50) nach Anspruch 6,
wobei die elektronische Plombiereinrichtung (145) ein Signal erzeugt oder verändert beim Öffnen der Vorrichtung (10), und/oder
wobei die elektronische Plombiereinrichtung (145) einen Reed-Kontakt umfasst, der im geschlossenen Zustand der Vorrichtung (10) geschlossen ist und im geöffneten Zustand der Vorrichtung (10) geöffnet ist.

8. Vorrichtung (10) zur Sicherung eines verriegelten Bajonettverschlusses (50) nach einem der Ansprüche 1 bis 7,
wobei das erste und das zweite Verriegelungssicherungselement (110, 120) jeweils ein Arretierelement (92, 94) aufweist, und
wobei das jeweilige Arretierelement (92, 94) dazu ausgebildet ist, die Vorrichtung (10) im geschlossen Zustand an einer axialen Bewegung bezogen auf den Bajonettverschluss (50) zu hindern.

9. Vorrichtung (10) zur Sicherung eines verriegelten Bajonettverschlusses (50) nach Anspruch 8,
wobei das jeweilige Arretierelement (92, 94) dazu ausgebildet ist, im geschlossenen Zustand in jeweils einen weiteren Freiraum (62, 72) des Bajonettverschlusses (50) einzugreifen oder hinter einen Steg des Bajonettverschlusses (50) zu greifen.

10. Bajonettverschluss (50) mit einer Vorrichtung (10) zur Sicherung gemäß Anspruch 9,
wobei die Bolzen (80, 90) des Bajonettverschlusses (50) und die weiteren Freiräume (62, 72) oder der Steg des Bajonettverschlusses (50) axial in abweichenden Positionen voneinander angeordnet sind.

11. Rogowski-Spule (200) mit einem Bajonettverschluss (50) mit einer Vorrichtung (10) zur Sicherung nach Anspruch 10,
wobei der Bajonettverschluss (50) im geöffneten Zustand eine Montage der Rogowski-Spule (200) um einen elektrischen Leiter erlaubt, und wobei der Bajonettverschluss (50) im geschlossenen Zustand eine Messanordnung der Rogowski-Spule (200) herstellt.

12. Rogowski-Spule (200) mit einem Bajonettverschluss (50) mit einer Vorrichtung (10) zur Sicherung nach Anspruch 11,
wobei ein Gesamtsignal einen Messwert der Rogowski-Spule (200) und das Signal (220) der elektronischen Plombiereinrichtung (145) umfasst.

13. Rogowski-Spule (200) mit einem Bajonettverschluss (50) mit einer Vorrichtung (10) zur Sicherung nach Anspruch 12,
wobei der Messwert der Rogowski-Spule (200) als Wechselstrom mit einer ersten Frequenz ausgebildet ist, optional der Netzfrequenz des gemessenen Stroms, und wobei das Signal der elektronischen Plombiereinrichtung (145) als Gleichstromsignal ausgebildet ist oder als Wechselstrom mit einer von der ersten Frequenz abweichenden zweiten Frequenz.

14. Rogowski-Spule (200) mit einem Bajonettverschluss (50) mit einer Vorrichtung (10) zur Sicherung nach einem der Ansprüche 11 bis 13,
wobei die Vorrichtung (10) nicht verlierbar an der zirkularen Leitung der Rogowski-Spule (200) angeordnet ist.

15. Rogowski-Spule (200) mit einem Bajonettverschluss (50) mit einer Vorrichtung (10) zur Sicherung nach Anspruch 14,
wobei die Vorrichtung (10) einen Ring oder ein Oval umfasst, der oder das um die zirkulare Leitung der Rogowski-Spule (200) angeordnet ist, wobei der Ring oder das Oval an das erste oder das zweite Verriegelungssicherungselement (110, 120) oder das Scharnier (125) gekoppelt ist.

## Claims

1. A device (10) for securing a locked bayonet coupling (50), comprising:
a first locking securing element (110), which is configured to surround the bayonet coupling (50) in a first region,
a second locking securing element (120), which is configured to surround the bayonet coupling (50) in a second region,
wherein the first and the second locking securing element (110, 120) each comprises a securing pin (150, 160), wherein the respective securing pin (150, 160) is configured to engage in each case in a free space (60, 70) of the bayonet coupling (50), which is traversed for an unlocking by a respective bolt (80, 90) of the bayonet coupling (50), and
wherein the unlocking of the bayonet coupling (50) is blocked when the first and the second locking securing element (110, 120) is arranged around the bayonet coupling (50).

2. The device (10) for securing a locked bayonet coupling (50) according to claim 1,
wherein the first locking securing element (110) and the second locking securing element (120) are connected or connectable to one another by a hinge (125),
wherein the device (10) is capable of assuming an open state for arranging the device (10) around the bayonet coupling (50) and a closed state for blocking the bayonet coupling (50).

3. The device (10) for securing a locked bayonet coupling (50) according to claim 1 or 2,
wherein the first locking securing element (110) and/or the second locking securing element (120) each has a recess (96, 98) for surrounding at least a part of the bayonet coupling (50), and wherein each of the recesses (96, 98) has a securing pin (150, 160), which projects into the respective free space (60, 70) of the bayonet coupling (50), optionally perpendicularly or radially.

4. The device (10) for securing a locked bayonet coupling (50) according to one of claims 1 to 3,
wherein the first locking securing element (110) and the second locking securing element (120) each has a bore (130, 135) for receiving a sealing wire (140), which is arranged such that a sealing wire (140) can be drawn through the bores (130, 135) in the closed state of the device (10).

5. The device (10) for securing a locked bayonet coupling (50) according to claim 4,
wherein the bore (130, 135) is arranged at an end of the locking securing elements (110, 120) opposite the hinge (125), and/or
wherein a length and/or form of the sealing wire (140) received in the bore (130, 135) presupposes the closed state of the device (10).

6. The device (10) for securing a locked bayonet coupling (50) according to one of claims 1 to 5,
wherein the first locking securing element (110) has a first component (146) of an electronic sealing device (145), and/or
wherein the second locking securing element (120) has a second component (148) of the electronic sealing device (145).

7. The device (10) for securing a locked bayonet coupling (50) according to claim 6,
wherein the electronic sealing device (145) generates or changes a signal when the device (10) is opened, and/or
wherein the electronic sealing device (145) comprises a reed contact, which is closed in the closed state of the device (10) and is open in the opened state of the device (10).

8. The device (10) for securing a locked bayonet coupling (50) according to one of claims 1 to 7,
wherein the first and the second locking securing element (110, 120) each has an arresting element (92, 94), and
wherein the respective arresting element (92, 94) is configured to prevent the device (10), in the closed state, from an axial movement with respect to the bayonet coupling (50).

9. The device (10) for securing a locked bayonet coupling (50) according to claim 8,
wherein the respective arresting element (92, 94) is configured to engage, in the closed state, in each case in a further free space (62, 72) of the bayonet coupling (50) or to engage behind a web of the bayonet coupling (50).

10. A bayonet coupling (50) with a device (10) for securing according to claim 9,
wherein the bolts (80, 90) of the bayonet coupling (50) and the further free spaces (62, 72) or the web of the bayonet coupling (50) are arranged axially in positions deviating from one another.

11. A rogowski coil (200) with a bayonet coupling (50) with a device (10) for securing according to claim 10,
wherein the bayonet coupling (50) in the opened state allows a mounting of the Rogowski coil (200) around an electric conductor, and wherein the bayonet coupling (50) in the closed state establishes a measuring arrangement of the Rogowski coil (200).

12. The rogowski coil (200) with a bayonet coupling (50) with a device (10) for securing according to claim 11,
wherein an overall signal comprises a measured value of the Rogowski coil (200) and the signal (220) of the electronic sealing device (145).

13. The rogowski coil (200) with a bayonet coupling (50) with a device (10) for securing according to claim 12,
wherein the measured value of the Rogowski coil (200) is formed as alternating current with a first frequency, optionally the mains frequency of the measured current, and wherein the signal of the electronic sealing device (145) is formed as a direct current signal or as alternating current with a second frequency deviating from the first frequency.

14. The rogowski coil (200) with a bayonet coupling (50) with a device (10) for securing according to one of claims 11 to 13,
wherein the device (10) is arranged in a captive manner on the circular line of the Rogowski coil (200).

15. The rogowski coil (200) with a bayonet coupling (50) with a device (10) for securing according to claim 14,
wherein the device (10) comprises a ring or an oval, which is arranged around the circular line of the Rogowski coil (200), wherein the ring or the oval is coupled to the first or the second locking securing element (110, 120) or the hinge (125).

## Revendications

1. Dispositif (10) de sécurisation d'une fermeture à baïonnette verrouillée (50), comprenant :
un premier élément de sécurisation du verrouillage (110), qui est conçu pour entourer la fermeture à baïonnette (50) dans une première zone,
un deuxième élément de sécurisation du verrouillage (120), qui est conçu pour entourer la fermeture à baïonnette (50) dans une deuxième zone,
le premier et le deuxième élément de sécurisation du verrouillage (110, 120) comportant chacun un pion de sécurisation (150, 160), le pion de sécurisation respectif (150, 160) étant conçu pour venir s'engager respectivement dans un espace libre (60, 70) de la fermeture à baïonnette (50), qui est parcouru en vue d'un déverrouillage par respectivement un boulon (80, 90) de la fermeture à baïonnette (50), et
le déverrouillage de la fermeture à baïonnette (50) étant bloqué lorsque le premier et le deuxième élément de sécurisation du verrouillage (110, 120) sont disposés autour de la fermeture à baïonnette (50).

2. Dispositif (10) de sécurisation d'une fermeture à baïonnette verrouillée (50) selon la revendication 1, le premier élément de sécurisation du verrouillage (110) et le deuxième élément de sécurisation du verrouillage (120) étant reliés entre eux ou aptes à être reliés entre eux par une charnière (125),
le dispositif (10) étant apte à adopter un état ouvert pour disposer le dispositif (10) autour de la fermeture à baïonnette (50) et un état fermé pour bloquer la fermeture à baïonnette (50).

3. Dispositif (10) de sécurisation d'une fermeture à baïonnette verrouillée (50) selon la revendication 1 ou 2,
le premier élément de sécurisation du verrouillage (110) et/ou le deuxième élément de sécurisation du verrouillage (120) comportant chacun un évidement (96, 98) pour entourer au moins une partie de la fermeture à baïonnette (50), et chacun des évidements (96, 98) comportant un pion de sécurisation (150, 160) qui fait saillie dans l'espace libre respectif (60, 70) de la fermeture à baïonnette (50), éventuellement perpendiculairement ou radialement.

4. Dispositif (10) de sécurisation d'une fermeture à baïonnette verrouillée (50) selon l'une des revendications 1 à 3,
le premier élément de sécurisation du verrouillage (110) et le deuxième élément de sécurisation du verrouillage (120) comportant chacun un perçage (130, 135) pour recevoir un fil de plombage (140), agencé de telle sorte qu'un fil de plombage (140) peut être introduit à travers les perçages (130, 135) à l'état fermé du dispositif (10).

5. Dispositif (10) de sécurisation d'une fermeture à baïonnette verrouillée (50) selon la revendication 4,
le perçage (130, 135) étant disposé à une extrémité des éléments de sécurisation du verrouillage (110, 120) opposée à la charnière (125), et/ou
une longueur et/ou une forme du fil de plombage (140) reçu dans le perçage (130, 135) présupposant l'état fermé du dispositif (10).

6. Dispositif (10) de sécurisation d'une fermeture à baïonnette verrouillée (50) selon l'une des revendications 1 à 5,
le premier élément de sécurisation du verrouillage (110) comportant un premier composant (146) d'un dispositif électronique de plombage (145), et/ou
le deuxième élément de sécurisation du verrouillage (120) comportant un deuxième composant (148) du dispositif électronique de plombage (145).

7. Dispositif (10) de sécurisation d'une fermeture à baïonnette verrouillée (50) selon la revendication 6,
le dispositif électronique de plombage (145) générant ou modifiant un signal lors de l'ouverture du dispositif (10), et/ou
le dispositif électronique de plombage (145) comprenant un contact Reed, qui est fermé à l'état fermé du dispositif (10) et ouvert à l'état ouvert du dispositif (10).

8. Dispositif (10) de sécurisation d'une fermeture à baïonnette verrouillée (50) selon l'une des revendications 1 à 7,
le premier et le deuxième élément de sécurisation du verrouillage (110, 120) comportant chacun un élément d'arrêt (92, 94), et
l'élément d'arrêt respectif (92, 94) étant conçu pour empêcher le dispositif (10), à l'état fermé, de se déplacer axialement par rapport à la fermeture à baïonnette (50).

9. Dispositif (10) de sécurisation d'une fermeture à baïonnette verrouillée (50) selon la revendication 8,
l'élément d'arrêt respectif (92, 94) étant conçu pour, à l'état fermé, venir s'engager respectivement dans un autre espace libre (62, 72) de la fermeture à baïonnette (50) ou venir se prendre derrière une nervure de la fermeture à baïonnette (50).

10. Fermeture à baïonnette (50) avec un dispositif (10) de sécurisation selon la revendication 9,
les boulons (80, 90) de la fermeture à baïonnette (50) et les autres espaces libres (62, 72) ou la nervure de la fermeture à baïonnette (50) étant disposés axialement dans des positions différentes les unes des autres.

11. Bobine de Rogowski (200) avec une fermeture à baïonnette (50) avec un dispositif (10) de sécurisation selon la revendication 10,
la fermeture à baïonnette (50) permettant, à l'état ouvert, un montage de la bobine de Rogowski (200) autour d'un conducteur électrique, et la fermeture à baïonnette (50) réalisant, à l'état fermé, une configuration de mesure de la bobine de Rogowski (200).

12. Bobine de Rogowski (200) avec une fermeture à baïonnette (50) avec un dispositif (10) de sécurisation selon la revendication 11,
un signal global comprenant une valeur de mesure de la bobine de Rogowski (200) et le signal (220) du dispositif électronique de plombage (145).

13. Bobine de Rogowski (200) avec une fermeture à baïonnette (50) avec un dispositif (10) de sécurisation selon la revendication 12,
la valeur de mesure de la bobine de Rogowski (200) étant réalisée sous forme de courant alternatif à une première fréquence, éventuellement la fréquence du réseau du courant mesuré, et le signal du dispositif électronique de plombage (145) étant réalisé sous forme de signal de courant continu ou sous forme de courant alternatif à une deuxième fréquence différente de la première fréquence.

14. Bobine de Rogowski (200) avec une fermeture à baïonnette (50) avec un
dispositif (10) de sécurisation selon l'une des revendications 11 à 13, le dispositif (10) étant disposé de manière imperdable sur la ligne circulaire de la bobine de Rogowski (200).

15. Bobine de Rogowski (200) avec une fermeture à baïonnette (50) avec un dispositif (10) de sécurisation selon la revendication 14,
le dispositif (10) comprenant un anneau ou un ovale, lequel ou laquelle est disposé autour de la ligne circulaire de la bobine de Rogowski (200), l'anneau ou l'ovale étant couplé au premier ou au deuxième élément de sécurisation du verrouillage (110, 120) ou à la charnière (125).
